# EUROPEAN PATENT APPLICATION

(11) **EP 4 776 068 A1**
(43) Date of publication of application: **15.07.2026**
(21) Application number: 25151642.3
(22) Date of filing: 14.01.2025
(51) Int. Cl.: G03F 7/00, G02B 7/02

(54) **THERMAL BARRIER ELEMENT**

(71) Applicant: ASML Netherlands B.V., 5500 AH Veldhoven (NL)
(72) Inventor: AJROEMJAN, Wahhe, 5500 AH Veldhoven (NL)
(74) Representative: ASML Netherlands B.V.

(57) **Abstract**

Disclosed herein is a thermal barrier element for a lens element. The thermal barrier element comprises a foil arrangement to be laminated to an outer surface of the lens element, and one or more conductive wires embedded in the foil arrangement. The conductive wires form strain gauges. A resistance of the one or more conductive wires changes as the foil arrangement delaminates from said outer surface.

## Description

### FIELD

The present invention relates to a thermal barrier element, a thermal barrier system, a lithographic apparatus and a method of detecting delamination in a thermal barrier.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") of a patterning device (e.g., a mask) onto a layer of radiation-sensitive material (resist) provided on a substrate (e.g., a wafer).

As semiconductor manufacturing processes continue to advance, the dimensions of circuit elements have continually been reduced while the amount of functional elements, such as transistors, per device has been steadily increasing over decades, following a trend commonly referred to as 'Moore's law'. To keep up with Moore's law the semiconductor industry is chasing technologies that enable to create increasingly smaller features. To project a pattern on a substrate a lithographic apparatus may use electromagnetic radiation. The wavelength of this radiation determines the minimum size of features which are patterned on the substrate. Typical wavelengths currently in use are 365 nm (i-line), 248 nm, and 193 nm.

Lithographic apparatus may be configured to contain a layer of immersion liquid arranged to cover at least part of the substrate during exposure. The lithographic apparatus comprises a lens element, which may be partly immersed in the immersion liquid. Occasionally, it is undesirable for the liquid to remain in contact with a portion of a lens side surface of the lens element. In some circumstances, for example due to movement of the substrate supporting stage, the immersion liquid may slosh and can leave a film or droplets of liquid on the lens side surface of the lens element. This is undesirable because evaporation of the droplets or film of immersion liquid at the lens side surface of the lens element can induce a thermal load on the lens side surface of the lens element. This thermal load can cause thermal instabilities, which may negatively impact the performance of the lithographic apparatus.

A thermal barrier may be provided in order to protect the lens element. The thermal barrier may comprise a foil arrangement to be laminated to an outer surface of the lens element. A disadvantage of thermal barrier elements is that it can be difficult to determine whether the foil arrangement has partially delaminated from the lens element. It is desirable to know whether (partial) delamination has occurred, because delamination can result in a decreased imaging performance due to the impact of thermal instabilities on the lens element.

However, even when the decrease in imaging performance is observed, it is not straightforward to determine whether the cause is delamination, or if there is a different cause. It has been necessary for a user to open the system and do a visual inspection to try to determine whether delamination has occurred. However, the opening of the system is a very costly operation, necessitating significant downtime of the system and risking the introduction of contaminants into the system.

### SUMMARY

It is an object of the present invention to provide a means to avoid the need to open the system in order to determine the cause of a decrease in imaging performance.

According to a first aspect of the invention, there is provided a thermal barrier element for a lens element. The thermal barrier element comprises a foil arrangement to be laminated to an outer surface of the lens element, and one or more conductive wires embedded in the foil arrangement. The conductive wires form strain gauges. A resistance of the one or more conductive wires changes as the foil arrangement delaminates (partially) from said outer surface.

According to another aspect of the invention, there is provided a thermal barrier system comprising the thermal barrier element and a detection unit. The detection unit is configured to detect delamination of the foil arrangement based on the changes in resistance of the one or more conductive wires. The one or more conductive wires are connected to the detection unit.

According to another aspect of the invention, there is provided a lithographic apparatus comprising the thermal barrier element.

According to another aspect of there invention, there is provided a method of detecting delamination in a thermal barrier element. The method comprises monitoring a level of resistance of the one or more conductive wires, and determining whether the foil arrangement is at least partly delaminated from the lens element, based on the resistance of the one or more conductive wires.

Further embodiments, features and advantages of the present invention, as well as the structure and operation of the various embodiments, features and advantages of the present invention, are described in detail below with reference to the accompanying drawings.

### DESCRIPTION OF THE DRAWINGS

Embodiments of the invention will now be described, by way of example only, with reference to the accompanying schematic drawings, in which corresponding reference symbols indicate corresponding parts, and in which:
Figure 1 depicts the schematic overview of the lithographic apparatus;
Figure 2 each depict, in cross section, a lens element with a thermal barrier element laminated thereon;
Figure 3 depicts a strain gauge comprising a conductive wire;
Figure 4 depicts a thermal barrier element including a conductive wire extending circumferentially around the foil arrangement;
Figures 5A-B depict different versions of the thermal barrier element having the one or more conductive wires in different positions;
Figure 6 depicts a thermal barrier element having a foil arrangement comprising two layers, wherein the conductive wires are disposed between the two layers;
Figure 7 depicts a plan view of a thermal barrier element comprising a plurality of regions.

The features shown in the figures are not necessarily to scale, and the size and/or arrangement depicted is not limiting. It will be understood that the figures include optional features which may not be essential to the invention. Furthermore, not all of the features of the apparatus are depicted in each of the figures, and the figures may only show some of the components relevant for describing a particular feature.

### DETAILED DESCRIPTION

In the present document, the terms "radiation" and "beam" are used to encompass all types of electromagnetic radiation, including ultraviolet radiation (e.g., with a wavelength of 365, 248, 193, 157, or 126 nm.

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. Besides the classic mask (transmissive or reflective, binary, phase-shifting, hybrid, etc.), examples of other such patterning devices include a programmable mirror array and a programmable LCD array.

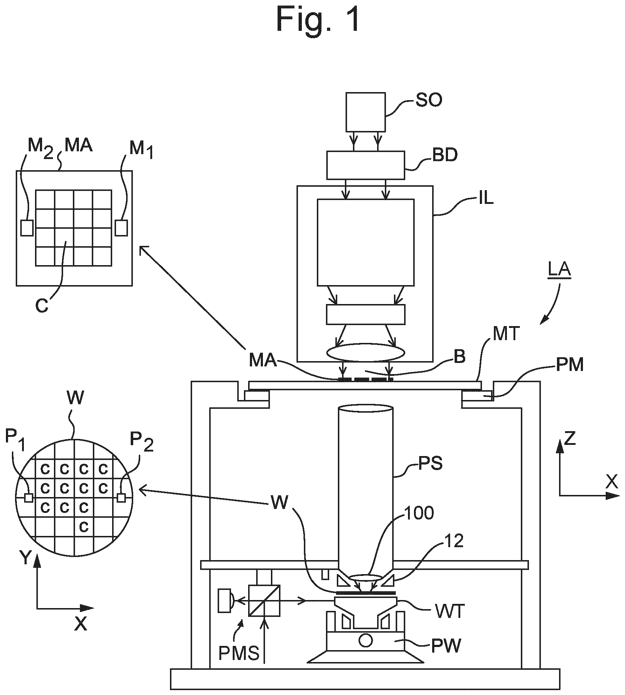

Figure 1 schematically depicts a lithographic apparatus LA. The lithographic apparatus LA includes an illumination system (also referred to as illuminator) IL configured to condition a radiation beam LB (e.g., UV radiation or DUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam LB by patterning device MA onto a target portion C (e.g., comprising one or more dies) of the substrate W.

In operation, the illumination system IL receives a radiation beam from a radiation source SO, e.g., via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam LB to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

Immersion techniques have been introduced into lithographic systems to enable improved resolution of smaller features. In an immersion lithographic apparatus, a liquid layer of immersion liquid having a relatively high refractive index is interposed in a space between a projection system of the apparatus (through which the patterned beam is projected towards the substrate W) and the substrate W (otherwise referred to as the sample). The immersion liquid covers at least the part of the sample W under a final element of the projection system PS. This lens element 100, which may be in contact with the immersion liquid, may be referred to as 'the last lens element' or "the final element". Thus, at least the portion of the sample W undergoing exposure is immersed in the immersion liquid. The effect of the immersion liquid is to enable imaging of smaller features since the exposure radiation will have a shorter wavelength in the liquid than gas. The effect of the immersion liquid may also be regarded as increasing the effective numerical aperture (NA) of the system and also increasing the depth of focus.

In commercial immersion lithography, the immersion liquid is water. Typically the water is distilled water of high purity, such as Ultra-Pure Water (UPW), which is commonly used in semiconductor fabrication plants. In an immersion system, the UPW is often purified and it may undergo additional treatment steps before supply to the immersion space as immersion liquid. Other liquids with a high refractive index can be used besides water can be used as the immersion liquid, for example: a hydrocarbon, such as a fluorohydrocarbon; and/or an aqueous solution. Further, other fluids besides liquid have been envisaged for use in immersion lithography.

In this specification, reference will be made in the description to localized immersion in which the immersion liquid is confined, in use, to the space between the final element 100 and a surface facing the final element. The facing surface is a surface of sample W or a surface of the supporting stage (or sample support WT) that is co-planar with the surface of the sample W. A fluid handling structure 12 present between the projection system PS and the sample support WT is used to confine the immersion liquid to the immersion space. The space filled by the immersion liquid is smaller in plan than the top surface of the sample W and the space remains substantially stationary relative to the projection system PS while the sample W and sample support WT move underneath.

The lithographic apparatus LA may also be of a type having two or more sample supports WT (also named "dual stage"). In such "multiple stage" machine, the sample supports WT may be used in parallel, and/or steps in preparation of a subsequent exposure of the sample W may be carried out on the sample W located on one of the sample support WT while another sample W on the other sample support WT is being used for exposing a pattern on the other sample W.

In addition to the sample support WT, the lithographic apparatus LA may comprise a measurement stage. The measurement stage is arranged to hold a sensor and/or a cleaning device. The sensor may be arranged to measure a property of the projection system PS or a property of the radiation beam LB. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam LB is incident on the patterning device, e.g., mask, MA which is held on the mask support MT, and is patterned by the pattern (design layout) present on patterning device MA. Having traversed the mask MA, the radiation beam LB passes through the projection system PS, which focuses the beam onto a target portion C of the sample W. To reach the sample W, the path of the radiation beam LB passes from the projection system PS through the immersion liquid confined by the fluid handling structure 12 between the projection system PS and the sample W. With the aid of the second positioner PW and a position measurement system IF, the substrate support WT can be moved accurately, e.g., so as to position different target portions C in the path of the radiation beam LB at a focused and aligned position. Similarly, the first positioner PM and possibly another position sensor (which is not explicitly depicted in Figure 1) may be used to accurately position the patterning device MA with respect to the path of the radiation beam LB. Patterning device MA and sample W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks, when these are located between the target portions C.

To clarify the invention, a Cartesian coordinate system is used. The Cartesian coordinate system has three axis, i.e., an x-axis, a y-axis and a z-axis. Each of the three axis is orthogonal to the other two axis. A rotation around the x-axis is referred to as an Rx-rotation. A rotation around the y-axis is referred to as an Ry-rotation. A rotation around about the z-axis is referred to as an Rz-rotation. The x-axis and the y-axis define a horizontal plane, whereas the z-axis is in a vertical direction. The Cartesian coordinate system is not limiting the invention and is used for clarification only. Instead, another coordinate system, such as a cylindrical coordinate system, may be used to clarify the invention. The orientation of the Cartesian coordinate system may be different, for example, such that the z-axis has a component along the horizontal plane.

As explained in more detail above, lithographic apparatus LA may be configured to contain a layer of immersion liquid arranged to cover at least part of the sample W during exposure. The immersion liquid may be contained by the fluid handling structure 12, which may surrounds the last (most downbeam) lens element 100 of the projection system PS. The immersion liquid may therefore be provided between the lens element 100 and the sample W during an exposure sequence. Thus the immersion liquid is in direct contact with a region of a surface of the lens element (which may be a central region) through which exposure radiation is transmitted. In some circumstances, for example due to movement of the substrate supporting stage, the immersion liquid may slosh and can leave a film or droplets of liquid on the lens side surface of the lens element 100. It is undesirable for a film or droplets of the immersion liquid to form on the lens side surface of the lens element 100 in a region of the lens element 100 (typically) not immersed in the immersion liquid. This is because evaporation of the film or droplets of immersion liquid at the lens element 100 can induce a thermal load on the lens element 100, and in particular on the lens side surface. This thermal load can cause thermal instabilities, which may negatively impact the performance of the lithographic apparatus.

A thermal barrier may be provided in order to protect the lens element 100 for undesired thermal loads. The thermal barrier may comprise a foil arrangement to be laminated to an outer surface of the lens element 100. A disadvantage of known thermal barrier elements, of the prior art, is that it can be difficult to determine whether the foil arrangement has partially delaminated from the lens element 100. It is desirable to know whether (partial) delamination has occurred, because delamination can result in a decreased imaging performance due to the impact of thermal instabilities on the lens element 100. However, even when the decrease in imaging performance is observed, it is not straightforward to determine whether the cause is delamination of the foil arrangement 10, or if there is a different cause. It has been necessary for a user to open the system, remove the fluid handling structure 12, and do a visual inspection to try to determine whether delamination has occurred. However, the opening of the system is a very costly operation, necessitating significant downtime of the system and risking the introduction of contaminants into the system. Furthermore, the thermal barrier may be replaced while the system is open, even if no delamination is observed, as a precautionary measure. This further reduces cost efficiency and is a waste of materials and time. There, therefore, exists a problem of how to more easily and efficiently identify whether the foil arrangement 10 has delaminated.

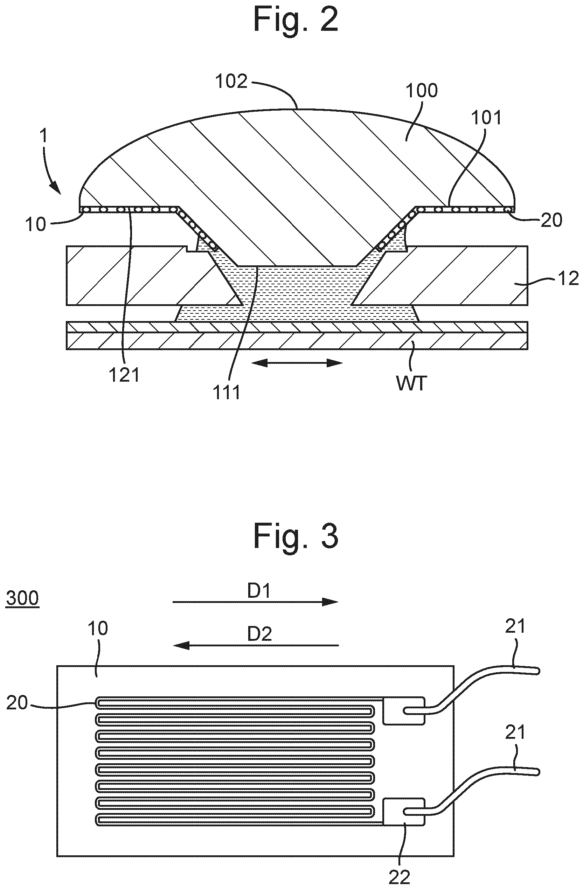

Figure 2 depicts a thermal barrier element 1. The thermal barrier element 1 of Figure 2 comprises a foil arrangement 10 to be laminated to an outer surface of the lens element 100. The thermal barrier element 1 of Figure 2 also comprises one or more conductive wires 20 embedded in the foil arrangement 10. The conductive wires 20 form strain gauges. In other words, the conductive wires 20 may be used to determine a strain in the foil arrangement, which can be indicative of delamination. In particular, a resistance of the one or more conductive wires 20 will change if the foil arrangement 10 delaminates from the outer surface of the lens element 100. The one or more conductive wires 20 therefore provide a means to determine whether or not the foil arrangement 10 has delamination from the lens element 100, without necessitating opening of the system for visual inspection. Although the thermal barrier element 1 is particularly useful in a region where there is immersion fluid, it is possible to apply the thermal barrier element 1 to provide protection in other scenarios, not in the presence of immersion fluid.

The one or more conductive wires 20 may form a strain gauge 300, for example as depicted in Fig. 3. The strain gauge 300 of Fig. 3 comprises a conductive wire 20 laid out in
a zig-zag arrangement (otherwise referred to as a meandering arrangement) with multiple parallel lengths aligned in the direction (directions D1 and D2) in which strain is to be measured. The conductive wire 20 is encapsulated in or on a surface of the foil arrangement 10, which is to be adhered to the surface of the lens element 100. Any deformation of the foil arrangement 10, for example due to delamination of the foil arrangement 10 from the lens element 100, will cause the length a of the zig-zag arrangement to change, e.g., increase. The change in length is multiplied by the number of parallel lengths of the conductive wire 20 to give the total change in length of wire 20 so that a measurable change in resistance of wire 20 occurs. Terminal wires 21 may connect the conductive wire 20 to an external detector unit. The terminal wires 21 may be connected to the conductive wire 20 using any suitable, electrically conductive means. For example, the terminal wires 21 may be connected to the conductive wire 20 and the foil arrangement 10 via (solder) pads 22.

The thermal barrier element 1 of Figure 2 is suitable for use on a lens element 100, such as in a lithographic apparatus LA. In a preferred arrangement, the thermal barrier element 1 may be provided on a lens element 100 of the lithographic apparatus LA, which is the lens element 100 closest to the substrate support WT. The thermal barrier element 1 is positioned on the lens element 100 at region other than the region 111 through which radiation passes towards the sample W. For example, the thermal barrier element 1 may be disposed on a lens side surface 121 of the lens element 100. As shown, for example, in Figure 2, the lens side surface 121 may be radially outward of the region 111 through which radiation passes towards the sample W during exposures. In particular, the thermal barrier element 1 may be disposed on a sample-facing side 101 of the lens element 100. The sample-facing side 101 faces towards the position at which the sample W is disposed during use. In other words, the sample-facing side 101 is on a downbeam side of the lens element 100 and is opposite to a projection system-facing side 102 on an upbeam side of the lens element 100. In this way, the thermal barrier element 1 may protect the lens side surface 121 on a sample-facing side 101 of the lens element 100. In this way, the thermal barrier element 1 may not interfere with the lens element 100 in the region 111 through which radiation passes towards the sample W during exposures. In particular, this region 111 may be immersed in immersion fluid on the sample-facing side 101 of the lens element 100. Meanwhile, the lens side surface 121, which is a surface most likely to be exposed to droplets of immersion fluid, for example due to sloshing as a result of sample support WT movement, may be protected by the thermal barrier element 1.

In a lithographic apparatus LA configured to contain immersion liquid, to partially or fully cover the sample W during exposure, the thermal barrier element 1 is preferably at least partially between the lens element 100 and the immersion liquid. In this way, the thermal barrier element 1 reduces a likelihood of liquid undesirably contacting portions of the lens element 100, and thus reduces thermal loading on the lens element 100.

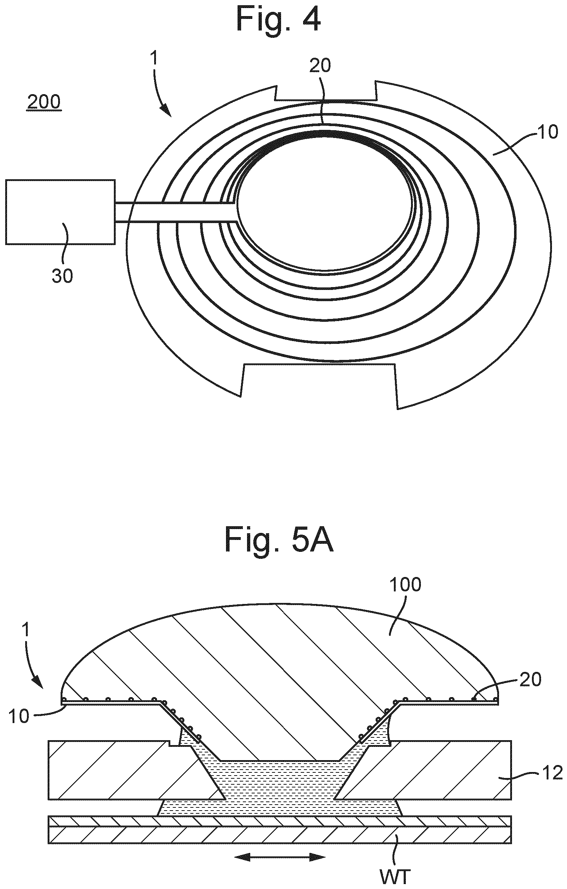

Figure 4 depicts a thermal barrier system 200 comprising a thermal barrier element 1, such as that described above in reference to Fig. 2. The thermal barrier system 200 may also comprise a detection unit 30 configured to detect delamination of the foil arrangement 10. The detection unit 30 of Fig. 4 is configured to detect delamination of the foil arrangement 10 based on changes in resistance of the one or more conductive wires 20.

In the thermal barrier system 200, during use, the one or more conductive wires 20 are connected to the detection unit 30. The one or more conductive wires 20 are preferably connected directly to the detection unit 30, as shown in Fig. 4. In another arrangement, the one or more conductive wires 20 may connect indirectly to the detection unit 30. For example, the one or more conductive wires 20 may connect directly to a transmitting unit. The transmitting unit may be configured to transmit data of the resistance of the one or more wires to the detection unit 30.

The detection unit 30 may optionally comprise one or more Wheatstone bridge circuits. For example, each end of each of the one or more conductive wires 20 may be connected to one of the one or more Wheatstone bridge circuits. The one or more Wheatstone bridge circuits may be used to determine a resistance of the one or more conductive wires 20.

The detection unit 30 may be disposed at a position remote from the rest of the lithographic apparatus LA. In particular, the detection unit 30 may be remote from the projection system PS. For example, the detection unit 30 may be disposed in a different chamber or a different room. In this way, the detection unit 30 can be used adaptably to avoid cluttering an area in close proximity to the rest of the lithographic apparatus LA in circumstances where there is limited space.

The thermal barrier unit 200 may be configured to determine whether or not the foil arrangement 10 has likely delaminated from the surface to which it is laminated. Delamination may be gradual and it is possible for some level of delamination to occur before there is a noticeable impact on the performance of the lithographic apparatus LA. The determination of whether or not delamination has occurred may be made reactively, in response to a degradation in performance being observed, or the thermal barrier element 1 may be continuously monitored in an effort to pro-actively determine that delamination has occurred in advance of noticeable performance issues. In either case, it is desirable to perform some level of monitoring to determine a baseline level of resistance of the one or more conductive wires 20. This is because a delamination will be most clearly demonstrated by an otherwise unexpected change in the resistance of the one or more conductive wires 20. It is therefore useful to perform sufficient monitoring in order to determine a baseline level or trend in the resistance of the one or more conductive wires 20, such that a notable change may be more readily identified.

The resistance of the one or more conductive wires 20 is preferably not measured during exposure by the lithographic apparatus LA. This is because the use of the lithographic apparatus LA for exposure may result in changes in other variables resulting in an errant measurement, which may falsely indicate a change in the resistance of the one or more conductive wires 20. For example, the immersion liquid may slosh during exposure such that liquid may contact the thermal barrier element 1 and influence the measurement.

The thermal barrier element 1 may, for example, be monitored by measuring the resistance of the one or more conductive wires 20 at intervals. If a change in the resistance of the one or more conductive wires 20 between intervals exceeds a predetermined change threshold, it may be determined that delamination has likely occurred.

The resistance of the one or more conductive wires 20 is monitored by measuring the resistance of the one or more conductive wires 20 at intervals selected by the user. For example, the user may opt to perform the measurements at predetermined intervals. The intervals may optionally be regular intervals. The predetermined intervals may, optionally be between one day and one month. For example, the predetermined interval may be one week. Alternatively, the user may opt to perform the measurements at irregular intervals, based on external factors. For example, the resistance of the one or more conductive wires 20 may be measured in response to it having been identified that there has been a decrease in imaging performance of the lithographic apparatus LA. For example, if aberrations of the image are seen to have increased in number or intensity, this may be indicative of possible delamination.

The user may manually initiate measurement at the desired time. Alternatively, the thermal barrier unit 200 may be configured to perform the measurement at the time or interval commanded by the user.

In one approach, a level of strain in the foil arrangement 10 may be estimated based on the resistance of the one or more conductive wires 20. It may then be determined whether the foil arrangement 10 is at least partly delaminated, based on the estimated level of strain in the foil arrangement 10, rather than directly based on the resistance of the one or more conductive wires 20. In particular, it may be determined whether the foil arrangement 10 is at least partly delaminated, based on a change in the estimated level of strain in the foil arrangement 10 exceeding a predetermined change threshold.

The one or more conductive wires 20 may be arranged in any desired pattern. For example, the one or more conductive wires 20 may be arranged to cover a wide area of the foil arrangement 10. Alternatively, or additionally, the one or more conductive wires 20 may be more densely arranged at a region of interest. A region of interest may be a region which is anticipated to be more likely to delaminate or a region in which delamination would be more likely to negatively influence performance. The one or more conductive wires 20 may extend in a circumferential direction around the foil arrangement 10. For example, as shown in Fig. 4, the one or more conductive wires 20 may be arranged in a substantially circular or elliptical pattern. Alternatively, the one or more conductive wires 20 may be arranged in a spiral or a meandering pattern around the foil arrangement. The spiral or meander may have a regular pattern. Alternatively, the spiral or meander could be more dense in a region of interest and comparatively less dense in other regions of the foil arrangement 10. In another arrangement, the one or more conductive wires 20 may extend in a substantially radial direction. For example, the one or more conductive wires 20 may extend in a direction from a center of the foil arrangement 10 towards a periphery of the foil arrangement 10.

Figure 5A depicts an arrangement of a thermal barrier element 1 similar to that of Fig. 2. The thermal barrier element of Fig. 5A differs from that of Fig. 2 in the placement of the one or more conductive wires 20 relative to the foil arrangement 10. In the arrangement of Fig. 2, the one or more conductive wires 10 are embedded in a centre of the foil arrangement 10; whereas in the arrangement of Fig. 5A, the one or more conductive wires 20 are disposed on an inner surface of the foil arrangement 10. The inner surface of the foil arrangement 10 is the surface configured to be adjacent the outer surface of the lens element 100. In other words, the inner surface of the foil arrangement 10 is the surface configured to contact the surface on which the foil arrangement is laminated. The arrangements of Fig. 2 and Fig. 5A have the advantage that the one or more conductive wires 20 are not on an outer surface of the foil arrangement 10, where the conductive wires may be more exposed to contaminants, such as immersion liquid, which may influence measurements.

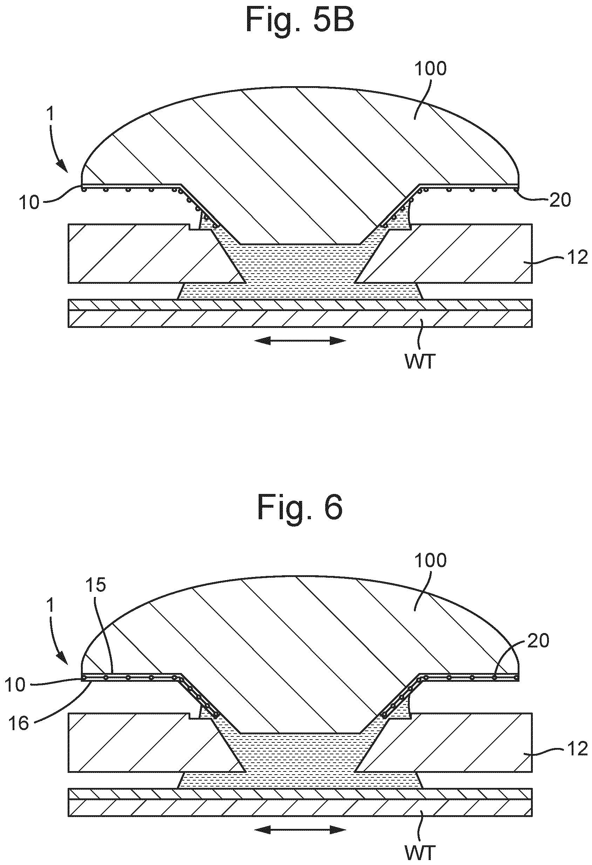

Figure 5B depicts an arrangement of a thermal barrier element 1 similar to that of Fig. 2. The thermal barrier element of Fig. 5B differs from that of Fig. 2 in the placement of the one or more conductive wires 20 relative to the foil arrangement 10. In the arrangement of Fig. 2, the one or more conductive wires 10 are embedded in a centre of the foil arrangement 10; whereas in the arrangement of Fig. 5B, the one or more conductive wires 20 are disposed on an outer surface of the foil arrangement 10. The outer surface of the foil arrangement 10 is the exposed surface, opposing the inner surface which is laminated, for example to the lens element 100. In other words, the outer surface of the foil arrangement 10 is the surface configured to be exposed to the immersion liquid. The arrangements of Fig. 2 and Fig. 5B have the advantage that the one or more conductive wires 20 are not in contact with the lens element 100, where the conductive wires may possibly damage the lens element and/or interfere with the performance of the lens element 100.

The foil arrangement 10 optionally comprises a plurality of layers 15, 16. For example, the thermal barrier element 1 of Fig. 6 comprises two layers 15, 16. In the arrangement on Fig. 6, an inner layer 15 includes the inner surface of the foil arrangement 10 and contacts the lens element 100, and an outer layer 16 includes the outer surface of the foil arrangement 10. Although the arrangement of Fig. 6 includes only two layers 15, 16, in other arrangements one or more further layers may be provided between the inner layer 15 and the outer layer 16. Furthermore, although in Fig. 6 the two layers 15, 16 are shown to cover the same region, in an alternative arrangement different layers may be different sizes. For example the inner layer 15 may cover a larger area than the outer layer 16. In such an example, the outer layer 16 may be provided only in the region or regions, which are determined to need most protection.

Figure 6 depicts an arrangement of a thermal barrier element 1 similar to that of Fig. 2. The thermal barrier element of Fig. 6 differs from that of Fig. 2 in the number of layers in the foil arrangement 10. In the arrangement of Fig. 2, the foil arrangement 10 consists of a single layer, and the one or more conductive wires 10 are embedded in a centre of the single layer of the foil arrangement 10. In the arrangement of Fig. 6, the foil arrangement 10 comprises two layers 15, 16 and the one or more conductive wires 20 are between the two layers 15, 16 of the foil arrangement 10. In other words, in arrangements wherein the foil arrangement 10 comprises more than one layer, the one or more conductive wires 20 may be disposed between adjacent layers of the foil arrangement 10. The arrangements of Fig. 2 and Fig. 6 have the advantage that the one or more conductive wires 20 are not in contact with the lens element or exposed to contaminants. Instead, the one or more conductive wires 20 are within the foil arrangement 10. With an arrangement such as this, the one or more conductive wires 20 may provide a more accurate indication of the condition of the foil arrangement 10. In arrangement such as that of Fig. 6 there is a further advantage that the one or more conductive wires may be fully embedded in the foil arrangement 10 while maintaining a relatively simple manufacturing process.

The foil arrangement 10 preferably comprises a hydrophobic material. For example, the foil arrangement 10 comprises a hydrophobic coating on an outer surface of the foil arrangement. In this way, the foil arrangement 10 may be more effective at reducing a likelihood that a film or droplets of immersion liquid remains on the lens element 100 after the liquid retracts, and subsequently evaporate resulting in a thermal load on the lens element 100. In one arrangement, the foil arrangement 10 may comprise a plurality of layers 15, 16, and one or more of the layers may comprise or consist of hydrophobic material. In a preferred arrangement, at least the outermost layer 16 may be formed of hydrophobic material. In other words, the outermost layer 16, which is on an opposite side of the foil arrangement 10 than the innermost layer 15, which contacts the lens element 100, may consist of hydrophobic material. Outer layer 16 may comprise a hydrophobic coating.

The foil arrangement 10 may comprises one or more of the following: polytetrafluoroethylene, polyethylene terephthalate, polyether ether ketone, and a metal. In an arrangement wherein the foil arrangement 10 comprises, or consists of, metal, the metal is preferably a non-magnetic metal.

The shape of the foil arrangement 10 is not particularly limited. The foil arrangement 10 may be shaped in order to accommodate the component, e.g., lens element 100, on which the foil arrangement 10 is to be laminated. For example, the foil arrangement 10 may have a shape which generally conforms to the shape of the lens element 100 such that the foil arrangement 10 can be readily laminated to the lens element 100 without there being significant gaps between the foil arrangement 10 and the lens element 100, because gaps may lead to leaks and could also increase a likelihood of delamination.

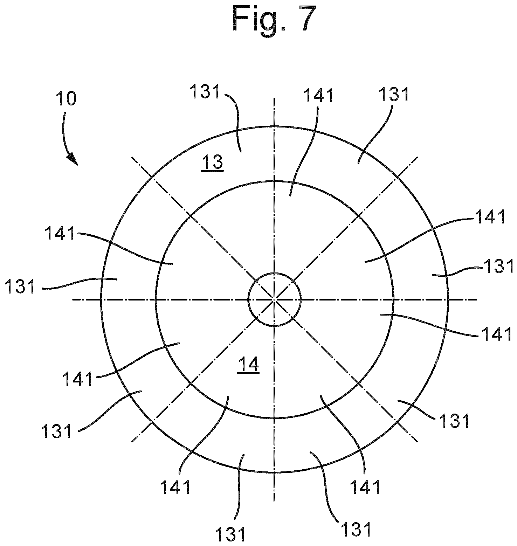

Figure 7 depicts a plan view of a foil arrangement 10. As shown, for example, in Fig. 2, and 4 to 7, the foil arrangement 10 may comprise an outer section 13 and an inner section 14. The outer section 13 preferably has an annular shape. The inner section 14 preferably has a frustoconical shape. The inner section 14 may be shaped such that a diameter at the lowermost part, configured to be closest to the sample during use, is smaller than a diameter at an uppermost part. The inner section 14 may be connected to the outer section 13 at the uppermost part of the inner section 14. The inner section 14 is disposed radially inwards of the outer section 13.

In a preferred arrangement, the inner section 14 and the outer section 13 may be integrally formed. In other words, the inner section 14 and the outer section 13 of the foil arrangement may be formed as a single component or piece.

Alternatively, in another arrangement, the inner section 14 and the outer section 13 may be separate parts configured to be connected together. For example, an inner rim of the outer section 13 may be configured to contact and interface with an outer rim of the inner section 14.

The one or more conductive wires 20 may be disposed on the outer section 13 and/or on the inner section 14 of the foil arrangement 10. In some arrangements, delamination in some regions of the foil arrangement 10 may be more critical to performance, e.g., of the lens element 100, than delamination in other regions of the foil arrangement 10. For example, it may be considered more important to detect delamination in the inner section 14, whereas delamination in the outer section 13 may occur without impacting on performance. For this reason, it may be preferable to dispose the one or more conductive wires 20 at least on the inner section 14 of the foil arrangement 10. The one or more conductive wires 20 may be disposed only on the inner section 14. Alternatively, the one or more conductive wires may be disposed on both the inner section 14 and the outer section 13 of the foil arrangement 10, but may be more densely arranged on the inner section 14 in order to improve the sensitivity of the strain gauge in the inner section 14.

According to another arrangement, the one or more conductive wires 20 may comprise a plurality of sets of conductive wires, wherein each set of conductive wires comprises one or more conductive wires. Each set of conductive wires is preferably disposed in a different region of the foil arrangement 10. In this arrangement, a resistance of the one or more conductive wires 20 of each set changes as the foil arrangement 10 delaminates from said outer surface in the region of the foil arrangement 10 corresponding to that set of conductive wires.

In one example arrangement, a first set of one or more conductive wires 20 may be provided in the inner section 14 and a second set of one or more conductive wires 20 may be provided in the outer section 13. In this way, a resistance of wires of the first set may be monitored separately to the resistance of wires of the second set. As a result, it may be determined whether or not a delamination has occurred, and whether the delamination is in a region corresponding to the inner section 14 of the foil arrangement 10 or in a region corresponding to the outer section 13 of the foil arrangement 10. A user may then decide that a delamination in a less critical region, such as corresponding to the outer section 13, may not require immediate further action particularly in the absence of a decrease in performance (such as evidenced by imaging aberrations of the lens element 100).

Figure 7 shows the foil arrangement 10 separated into a plurality of regions. The regions of Fig. 7 include different sectors 131, 141 of the foil arrangements 10. In other words, there may be a plurality of circumferentially arranged sectors 131, 141. The sets of conductive wires may be arranged in the different sectors such that it may be determined when delamination has occurred and in which sector 131, 141. It may therefore be possible to determine where a likely delamination has occurred, and for the user to decide whether this is a critical issue. Furthermore, it may be possible to track the progression of a delamination if it is determined that likely delamination has occurred in adjacent regions. It may therefore be possible to determine at which stage the delamination begins to have a notable influence on performance and to take action. In this way, unnecessary action in response to small delamination in a non-critical area may be avoided, while still monitoring to respond appropriately if/when a more critical area is affected.

In the example arrangement shown in Fig. 7 there are 8 sectors 131, 141, which may correspond to 8 regions each being associated with a corresponding set of one or more conductive wires 20. Optionally, each of the 8 sectors may be spilt to form a plurality of regions. For example, the 8 sectors 141 of the inner section 14 may form 8 regions, and the 8 sectors 131 of the outer section 13 may form 8 regions for a total of 16 regions. The number of regions is not particularly limited. For example, there may be between 2 and 12, preferably between 4 and 10, more preferably between 6 and 8 sectors around a circumference of the foil arrangement 10. Each sector 131, 141, may optionally be spit to form different, radially arranged, regions. The radially arranged regions may correspond to the outer and inner sections 13, 14 of the foil arrangement 10, as shown in Fig. 7. Alternatively, the number of radially arranged regions, or rings, may differ from the number of sections. For example, the inner section 14 may comprise an inner ring of regions and an outer ring of regions. In this way, the number of regions, and corresponding number of sets of conductive wires 20, may be provided as suited to the particular situation and the level of detail desired in terms of the location of delamination on the foil arrangement 10.

The one or more conductive wires 20 may extend in a circumferential direction and/or a radial direction, as explained above in regard to Figure 4. For example, in a foil arrangement 10 comprising a plurality of radially arranged, circumferentially extending regions, the conductive wires 20 may extend in a circumferential direction (e.g., in a circular, or spiral pattern). In a foil arrangement 10 comprising a plurality of circumferentially arranged, radially extending regions, the conductive wires 20 may extend in a radial direction, forming a spoke-like pattern. Alternatively, the conductive wires 20 may be arranged in a meandering pattern within the corresponding region.

Although specific reference may be made in this text to embodiments of the invention in the context of a lithographic apparatus, embodiments of the invention may be used in other apparatus. Embodiments of the invention may form part of a metrology apparatus, or any apparatus that measures or processes an object such as a wafer (or other substrate). These apparatus may be generally referred to as lithographic tools.

Embodiments include the following numbered clauses:
1. A thermal barrier element for a lens element, comprising
   a foil arrangement to be laminated to an outer surface of the lens element, and
   one or more conductive wires embedded in the foil arrangement, said conductive wires form strain gauges,
   wherein a resistance of the one or more conductive wires changes as the foil arrangement delaminates from said outer surface.
2. The thermal barrier element of clause 1, wherein the foil arrangement comprises a plurality of layers.
3. The thermal barrier element of clause 2, wherein the one or more conductive wires are disposed between adjacent layers of the foil arrangement.
4. The thermal barrier element of either of clauses 1 and 2, wherein the one or more conductive wires are disposed on an inner surface of the foil arrangement, wherein the inner surface of the foil arrangement is adjacent the outer surface of the lens element.
5. The thermal barrier element of either of clauses 1 and 2, wherein the one or more conductive wires are disposed on an outer surface of the foil arrangement.
6. The thermal barrier element according to any preceding clause, wherein the foil arrangement comprises a hydrophobic material.
7. The thermal barrier element of clause 6, wherein the foil arrangement comprises a one or more layers consisting of the hydrophobic material.
8. The thermal barrier element of clause 6 or 7, wherein the foil arrangement comprises a hydrophobic coating on an outer surface of the foil arrangement.
9. The thermal barrier element of any preceding clause, wherein the foil arrangement comprises one or more of: polytetrafluoroethylene, polyethylene terephthalate, polyether ether ketone, and a metal.
10. The thermal barrier element of clause 9, wherein the metal is a non-magnetic metal.
11. The thermal barrier element according to any preceding clause, wherein the foil arrangement comprises an outer section having an annular shape.
12. The thermal barrier element according to any preceding clause, wherein the foil arrangement comprises an inner section having a frustoconical shape.
13. The thermal barrier element of clause 12, when dependent on clause 11, wherein the inner section is disposed radially inwards of the outer section.
14. The thermal barrier element of clause 13, wherein the inner section and the outer section are integrally formed.
15. The thermal barrier element of clause 13, wherein the inner section and the outer section are separate parts configured to be connected together.
16. The thermal barrier element according to any preceding clause, wherein the one or more conductive wires are arranged in a spiral or a meandering pattern around the foil arrangement.
17. The thermal barrier element of clause 16, when dependent on any of clauses 12 to 15, wherein the one or more conductive wires is disposed on the inner section of the foil arrangement.
18. The thermal barrier element according to any preceding clause, wherein
   the one or more conductive wires comprises a plurality of sets of conductive wires, and each set of conductive wires comprises one or more conductive wires,
   each set of conductive wires is disposed in a different region of the foil arrangement, and a resistance of the one or more conductive wires of each set changes as the foil arrangement delaminates from said outer surface in the region of the foil arrangement corresponding to that set of conductive wires.
19. The thermal barrier element of clause 18, wherein the sets of conductive wires are arranged in regions forming sectors of the foil arrangement.
20. The thermal barrier element of clause 19, wherein there are between 4 and 10 regions around a circumference of the foil arrangement.
21. The thermal barrier element according to any preceding clause, wherein the one or more conductive wires are configured to connect to a detection unit.
22. A thermal barrier system comprising the thermal barrier according to any preceding clause, further comprising a detection unit configured to detect delamination of the foil arrangement based on the changes in resistance of the one or more conductive wires, wherein the one or more conductive wires are connected to the detection unit.
23. The thermal barrier system according to clause 22, wherein the detection unit comprises one or more Wheatstone bridge circuits, wherein each end of each of the one or more conductive wires is connected to one of the one or more Wheatstone bridge circuits
24. A lithographic apparatus for forming a pattern on a sample, comprising the thermal barrier element of any of clauses 1 to 21, and the lens element on which the foil arrangement is laminated.
25. The lithographic apparatus of clause 24, wherein the thermal barrier element is disposed on a sample-facing side of the lens element, facing towards the position at which the sample is disposed during use.
26. The lithographic apparatus of either of clauses 24 and 25, wherein the thermal barrier element is between the lens element and the position at which the sample is disposed during use.
27. The lithographic apparatus of any of clauses 24 to 26, further comprising a layer of immersion liquid arranged to cover at least part of the sample during use, wherein the thermal barrier element is at least partially between the lens element and the liquid immersion liquid.
28. A lithographic system comprising the lithographic apparatus of any of clauses 22 to 25, further comprising a detection unit configured to detect delamination of the foil arrangement based on the changes in resistance of the one or more conductive wires, wherein the one or more conductive wires are connected to the detection unit.
29. The lithographic system of clause 28, wherein the detection unit comprises one or more Wheatstone bridge circuits, wherein each end of each of the one or more conductive wires is connected to one of the one or more Wheatstone bridge circuits.
30. The lithographic system of either of clauses 28 and 29, wherein the detection unit is remote from the lithographic apparatus.
31. A method of detecting delamination in a thermal barrier according to any of clauses 1 to 21, the method comprising
   monitoring a level of resistance of the one or more conductive wires, and
   determining whether the foil arrangement is at least partly delaminated from the lens element, based on the resistance of the one or more conductive wires.
32. The method of clause 31, further comprising estimating a level of strain in the foil arrangement based on the resistance of the one or more conductive wires, and determining whether the foil arrangement is at least partly delaminated from the lens element, based on the estimated level of strain in the foil arrangement.
33. The method of either of clauses 31 and 32, wherein the resistance of the one or more conductive wires is monitored by measuring the resistance of the one or more conductive wires at predetermined intervals.
34. The method of clause 33, wherein the predetermined intervals are between one day and one week.
35. The method of any of clauses 31 to 34, wherein it is determined that the foil arrangement is at least partly delaminated from the lens element when a change in resistance of the one or more conductive wires exceeds a predetermined threshold.
36. The method of any of clauses 31 to 35, wherein the foil arrangement is formed on a lens element of a lithographic apparatus, and wherein the resistance of the one or more conductive wires is measured at times different to exposure times during which the lithographic apparatus is not performing exposure.
37. The method of either of clauses 31 and 36, wherein the resistance of the one or more conductive wires is measured in response to a decrease in imaging performance of the lithographic apparatus.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A thermal barrier element for a lens element, comprising
a foil arrangement to be laminated to an outer surface of the lens element, and
one or more conductive wires embedded in the foil arrangement, said conductive wires form strain gauges,
wherein a resistance of the one or more conductive wires changes as the foil arrangement delaminates from said outer surface.

2. The thermal barrier element of claim 1, wherein the foil arrangement comprises a plurality of layers.

3. The thermal barrier element of claim 2, wherein the one or more conductive wires are disposed between adjacent layers of the foil arrangement.

4. The thermal barrier element according to any preceding claim, wherein the foil arrangement comprises a hydrophobic material.

5. The thermal barrier element of any preceding claim, wherein the foil arrangement comprises one or more of: polytetrafluoroethylene, polyethylene terephthalate, polyether ether ketone, and a metal.

6. The thermal barrier element according to any preceding claim, wherein the foil arrangement comprises an inner section having a frustoconical shape.

7. The thermal barrier element according to any preceding claim, wherein the one or more conductive wires are arranged in a spiral or a meandering pattern around the foil arrangement.

8. The thermal barrier element according to any preceding claim, wherein
the one or more conductive wires comprises a plurality of sets of conductive wires, and each set of conductive wires comprises one or more conductive wires,
each set of conductive wires is disposed in a different region of the foil arrangement, and a resistance of the one or more conductive wires of each set changes as the foil arrangement delaminates from said outer surface in the region of the foil arrangement corresponding to that set of conductive wires.

9. A thermal barrier system comprising the thermal barrier element according to any preceding claim, further comprising a detection unit configured to detect delamination of the foil arrangement based on the changes in resistance of the one or more conductive wires, wherein the one or more conductive wires are connected to the detection unit.

10. The thermal barrier system according to claim 9, wherein the detection unit comprises one or more Wheatstone bridge circuits, wherein each end of each of the one or more conductive wires is connected to one of the one or more Wheatstone bridge circuits

11. A lithographic apparatus for forming a pattern on a sample, comprising the thermal barrier element of any of claims 1 to 8, and the lens element on which the foil arrangement is laminated.

12. A method of detecting delamination in a thermal barrier element according to any of claims 1 to 8, the method comprising
monitoring a level of resistance of the one or more conductive wires, and
determining whether the foil arrangement is at least partly delaminated from the lens element, based on the resistance of the one or more conductive wires.

13. The method of claim 12, further comprising estimating a level of strain in the foil arrangement based on the resistance of the one or more conductive wires, and determining whether the foil arrangement is at least partly delaminated from the lens element, based on the estimated level of strain in the foil arrangement.

14. The method of claim 12 or 13, wherein it is determined that the foil arrangement is at least partly delaminated from the lens element when a change in resistance of the one or more conductive wires exceeds a predetermined threshold.

15. The method of either of claims 12 and 14, wherein the resistance of the one or more conductive wires is measured in response to a decrease in imaging performance of the lithographic apparatus.
